# EUROPÄISCHE PATENTSCHRIFT

(11) **EP 1 529 218 B1**
(45) Veröffentlichungstag und Bekanntmachung des Hinweises auf die Patenterteilung: **21.10.2009**
(21) Anmeldenummer: 03790773.0
(22) Anmeldetag: 12.05.2003
(51) Int. Cl.: G01R 11/24

(54) **GEHÄUSE FÜR EINEN ZÄHLER**
HOUSING FOR A METER
BOITIER DE COMPTEUR

(30) Priorität: 09.08.2002 EP 02017955
(43) Veröffentlichungstag der Anmeldung: 11.05.2005
(73) Patentinhaber: Landis+Gyr AG, 6300 Zug (CH)
(72) Erfinder: HALLER, Hans-Peter, CH-6330 Cham (CH)
(74) Vertreter: Lagler, Louis
(86) Internationale Anmeldenummer: PCT/EP2003/004910
(87) Internationale Veröffentlichungsnummer: WO 2004/021020

(56) Entgegenhaltungen:
- EP-A- 0 649 025
- DE-U- 20 001 279
- GB-A- 635 235
- GB-A- 2 276 728
- GB-A- 2 301 192
- GB-A- 2 334 338
- US-A- 4 654 662

## Beschreibung

Die Erfindung betrifft ein Gehäuse für einen Zähler, insbesondere für Elektrizitätszähler, Gaszähler, Wärmezähler oder dergleichen, wobei das Gehäuse eine Gehäuseabdeckung aufweist.

### Technologischer Hintergrund und Stand der Technik

Bekannt sind Gehäuse, die beispielsweise bei elektrischen/elektronischen Geräten, wie Elektrizitätszähler, Gaszähler, Wärmezähler oder dergleichen, zum Einsatz gelangen. Eine Besonderheit an Zählergehäusen ist, dass sie gegen unberechtigten Zugriff mittels einer Plombierung geschützt werden. Hierfür verbindet diese Plombierung in der Regel die Gehäuseabdeckung mit dem Gehäuseboden, wobei unter anderem die Zähleranschlüsse abgedeckt werden.

Zumeist sind Gehäuseabdeckungen dieser Art zweiteilig ausgeführt, insbesondere bei Elektrizitätszählern. Eine erste, obere Gehäuseabdeckung verschliesst dabei den Messsignalerfassungs- bzw. den Elektronikteil des Zählers und eine zweite, untere Gehäuseabdeckung schützt die Anschlüsse zum Zähler.

Dieser die Zähleranschlüsse verschliessende Abdeckungsteil wird auch Klemmendeckel genannt.

GB 2301192 offenbart ein Zählergehäuse mit mehreren Plombierungen. Eine erste Plombierung sicher eine Schraube 26 und damit einen Gehäusedeckel 12 vor unberechtigten Zugriff, eine zweite Plombierung sichert eine Schraube 30 eines Klemmendeckels 28 und eine dritte Plombierung sichert eine Schraube 42 einer Zusatzabdeckung 36 der Ausgangsklemmen 22, 24. Der Gehäusedeckel 12 deckt einen oberen zählergehäuseteil ab, lässt aber den Klemmenblock am unteren Zählergehäuseteil frei. Der Klemmendeckel 28 deckt den Klemmenblock 16 vollständig ab, mit Aufnahme der Ausgangsklemmen 22, 24, die mit einer "eigenen" Zusatzabdeckung 36 vor einem Zugriff gesichert werden. In D1 gelangt somit eine hierarchische Plombierungsphilosophie zur Anwendung, die unterschiedliche Zugriffsberechtigungen zu einem Zähler erlaubt. Jeder Plombierung sind "eigene" Bereiche zugeordnet, die einzelne Vorrichtungen eines Zählers sicheren.

Auch GB 2276728 verfolgt das Prinzip einer gestuften Zugriffsberechtigung. Mittels einer ersten, plombierbaren Abdeckung 39 werden lediglich Eingangsklemmen 33, 34 eines Zählers verschlossen und mit einer separaten, plombierbaren Abdeckung 41 nur Ausgangsklemmen 36, 37. Dabei überlappt die separate Abdeckung 41 die erste Abdeckung 39 teilweise, nicht aber die Eingangsklemmen 33, 34.

Die EP 0649025 offenbart ein Zählergehäuse, bei dem ein Gehäusedeckel 3 lediglich einen oberer Gehäuseteil abdeckt und einen lediglich einen Klemmenblock verschliessenden Klemmendeckel 2, der durch eine Klemmendeckelplombe 4 gegen unberechtigtes Öffnen gesichert ist. Der Gehäusedeckel 3 ist mit einer Gehäusedeckelplombe 11 gesichert, die erst dann freigelegt wird, wenn der Klemmendeckel 2 entfernt wird.
Mittels eines solchen Klemmendeckels wird bei Elektrizitätszahlern der gesamte Anschlussklemmenbereich geschützt nebst den zu Prüfzwecken in unmittelbarer Nähe ebenfalls installierten, sogenannten Spannungsbrücken. Derartige Spannungsbrücken erlauben ein einfaches Trennen der Messzweige für die Spannungsmessung und die Strommessung zum Abgleich dieser Messpfade bzw. zur Eichprüfung.

Eine Ausführungsform derartiger Spannungsbrücken umfasst herkömmliche, verschraubbare Schiebebrücken; eine andere Ausgestaltungsform sieht hingegen eine Kontaktfederbrückenanordnung vor, wie sie in der CH 683801 gezeigt ist. Diese Kontaktfederbrücke ermöglicht eine äusserst einfache Bedienung bei der Trennung der Messpfade, da lediglich eine elektrische Prüfspitze derart eingeführt werden muss, dass die Kontaktfeder die Messkreise trennt und gleichzeitig den Spannungsmesspfad mit einer Prüfspannung beaufschlagt. Der Zugang zu diesen Kontaktfedern erfolgt durch Führungsbohrungen in einer Gehäusewand zwischen dem Anschlussklemmenblock und dem Inneren des Zählers mit dem Mess- bzw. Elektronikteil.

Bei langjährigem Einsatz von Zählern mit Spannungsbrücken in Form von Kontaktfedern hat sich gezeigt, dass bei geöffnetem Klemmendeckel am Installationsort der Zähler eine unzulässige, auf Anhieb schlecht nachweisbare Manipulation der Spannungsbrücken erfolgen kann, was im ungünstigsten Fall sogar zum Ausfall des gesamten Zählers führen kann.

### Darstellung der Erfindung

Es ist deshalb Aufgabe der Erfindung Gehäuse der oben beschriebenen Art dahingehend weiterzubilden, dass unter Ausnutzung aller Vorteile der oben beschriebenen, komfortablen Spannungsbrücke in Form der Kontaktfederanordnung, ein verbesserter Schutz gegen unberechtigte Manipulation gewährt wird.

Diese Aufgabe wird erfindungsgemäss gelöst durch die Merkmale des Anspruchs 1.

Der Kern der Erfindung ist darin zu sehen, dass bei einem Gehäuse für einen Zähler mittels einer plombierbaren Gehäuseabdeckung, die die Zähleranschlüsse abdeckt, mindestens eine weitere Zählervorrichtung abgedeckt ist, die mittels einer zweiten Plombierung gegen unberechtigten Zugriff schützbar ist.

Eine konkrete Ausführungsform sieht vor, dass auf vorteilhafte Weise mit der Erfindung eine Spannungsbrücke eines Elektrizitätszählers mit einer zusätzlichen Plombierung selbst dann noch geschützt ist, wenn der sie ebenfalls abdeckende und ansonsten ebenfalls plombierte Klemmendeckel nicht installiert ist. Derartige klemmendeckelfreie Zustände sind vor allem dort bekannt, wo mit einer ersten Gehäuseabdeckung lediglich grösster Wert auf den Schutz der Mess- bzw. Elektronikeinheit eines Zählers gelegt wird und der Schutz der Zähleranschlüsse mittels einer zweiten Gehäuseabdeckung in Form eines Klemmendeckels zumindest zeitweise vernachlässigt wird. In solchen Fällen ist von grösstem Vorteil, dass an dem Zählergehäuse zum Schutz der Spannungsbrücke eine weitere, eigene Plombierung vorgesehen ist. Herauszuheben ist dabei, dass diese erfindungsgemässe Plombierung einer weiteren zu schützenden Zählervorrichtung so gestaltet ist, dass sie bei klemmendeckelfreiem Zustand frei zugänglich ist und somit visuell einfach und schnell überprüfbar ist.

Weitere vorteilhafte Ausgestaltungen der Erfindung sind Gegenstand der abhängigen Ansprüche 2 bis 16.

Mit Vorteil wird die zu schützende Zählervorrichtung mit einer Zusatzabdeckung abgedeckt ist, wobei diese Zusatzabdeckung gegen unberechtigtes Entfernen plombiert wird.

Besonders einfach und sicher ist die Verwendung eines Riegels als Zusatzabdeckung, der in Gehäusenuten und/oder hinter Gehäusestegen gehalten wird und eine frei zugängliche Plombierbohrung zur Sicherung aufweist.

Eine vorteilhafte Ausgestaltung der Erfindung sieht vor, dass das Zählergehäuse mindestens eine Plombieröse aufweist, mit der die Plombierbohrung der Zusatzabdeckung zusammenwirkt, wobei ein Plombierstift durch die mindestens eine Plombieröse und die Plombierbohrung als Bindeglied funktioniert. Dabei ist besonders vorteilhaft, wenn die mindestens eine Plombieröse von der Plombierbohrung beabstandet angeordnet ist, so dass eine Sollbruchstelle des Plombierstiftes zwischen ihnen sichtbar ist.

Darüber hinaus ist vorteilhaft, wenn das Gehäuse eine zweite Plombieröse aufweist, die von der mindesten einen, ersten Plombieröse beabstandet angeordnet ist, wobei sich zwischen diesen Plombierösen eine Art Sichtfenster für die Sollbruchstelle des Plombierstiftes ergibt. Dabei kann die Plombierbohrung entweder innerhalb oder ausserhalb dieses Sichtfensters angeordnet sein.

Von besonderem Vorteil ist, wenn der Plombierstift aus einem Kunststoff besteht, insbesondere aus einem transparenten Kunststoff, da somit eine Überprüfung desselben einfach und schnell möglich ist. Transparente Plombierstifte offenbaren nämlich unmittelbar jede an ihnen verübte Manipulation.

Mit Vorteil tragen die Plombierstifte nach ihrer Installation einen Prägestempelung mit Hinweisen auf die Eichbehörde und/oder das Eichdatum.

### Kurze Darstellung der Zeichnung

In der Zeichnung ist ein Ausführungsbeispiel der Erfindung vereinfacht dargestellt. Es zeigt:
- Fig. 1: eine perspektivische Schnittdarstellung eines erfindungsgemässen Gehäuses mit einer plombierbaren Zusatzabdeckung unter einem plombierbaren Klemmendeckel;
- Fig. 2: eine als Riegel ausgebildete Zusatzabdeckung;
- Fig. 3: eine perspektivische Darstellung einer erfindungsgemäss zu schützenden Spannungsbrücke (Stand der Technik, CH 683801), und
- Fig. 4: eine Plombierung des Riegels.

Im folgenden wird die Erfindung anhand der Zeichnung detailliert erörtert. Dabei ist anzumerken, dass die Erfindung keinesfalls auf die Darstellung in dieser Zeichnung zu reduzieren ist. So ist beispielsweise nicht nur eine Spannungsbrücke mit der Erfindung schützbar, sondern jede weitere Zusatzvorrichtung eines Zählers, die selbst dann noch plombiert sein muss, wenn ein zugehöriges Zählergehäuseabdeckungsteil nicht installiert ist.

### Wege zur Ausführung der Erfindung

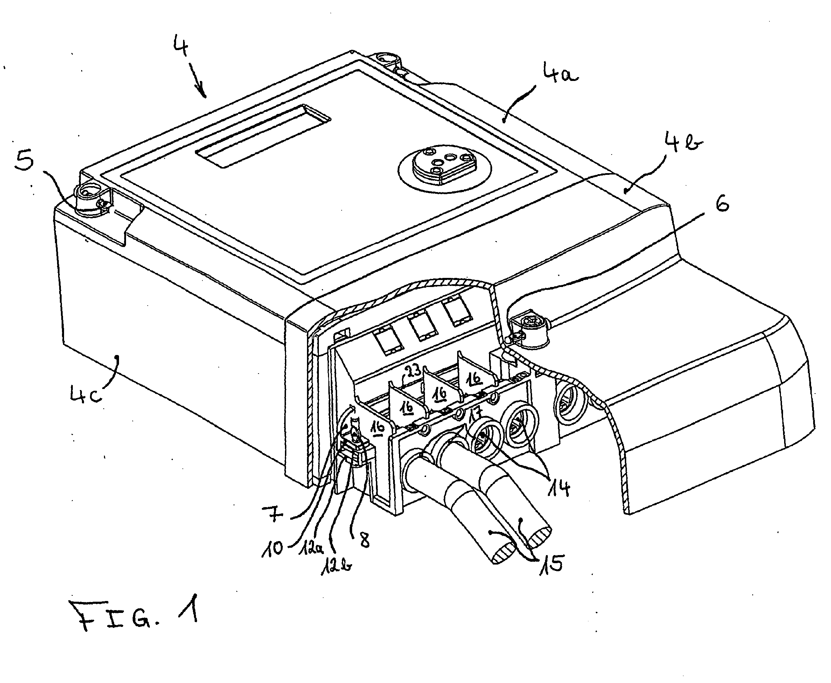

Fig. 1 zeigt in einer perspektivischen Schnittdarstellung ein Zählergehäuse 4. Dieses Zählergehäuse 4 ist als Elektrizitätszählergehäuse ausgebildet und hier lediglich als spezielle Ausgestaltung eines im allgemeinen bekannten Zählergehäuses anzusehen. Das Zählergehäuse 4 umfasst ein Gehäuseunterteil 4c, das von einer ersten Gehäuseabdeckung 4a und von einer zweiten Gehäuseabdeckung 4b verschlossen wird. Die zweite Gehäuseabdeckung 4b ist in dem vorliegenden Fall als Klemmendeckel ausgebildet und wird im Folgenden auch so benannt.

Gegen unbefugten Zugriff ist sowohl die erste Gehäuseabdeckung 4a, wie auch der Klemmendeckel 4b jeweils mit einer Plombierung 5 bzw. 6 versehen. Der Klemmendeckel 4b schützt die unter ihm angeordneten Klemmen 14 und daran angeschlossenen Leiter 15. Die Leiter 15 sind durch Anschlussöffnungen 17 im Gehäuseunterteil 4c in die Klemmen 14 geführt angeordnet.

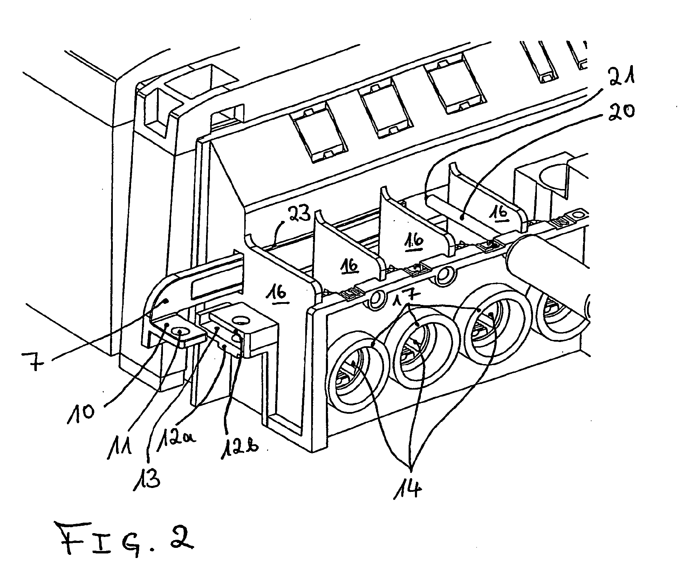

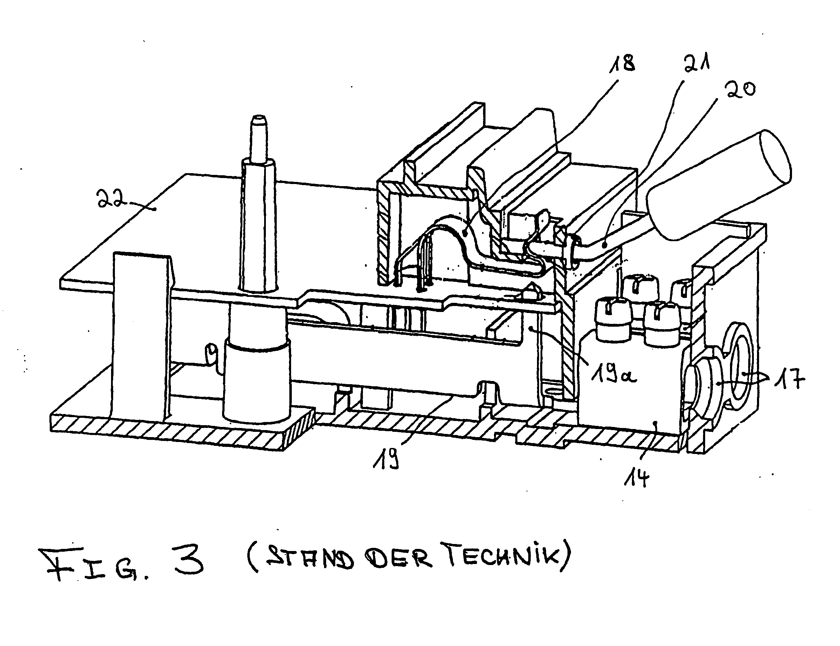

Neben den zugriffsgeschützten Klemmen 14 und Leitern 15 wird durch eine Zusatzabdeckung 7 in Form eines Riegels eine weitere - hier nicht dargestellte - zu schützende Zusatzvorrichtung 18, bzw. Zugangsöffnungen 21 dazu, abgedeckt, die weiter unten in Verbindung mit den Fig. 2 und 3 näher erläutert werden.

An dem Riegel 7 ist eine Konsole 10 angeformt, mit der der Riegel an mindestens einer der Plombierösen 12a oder 12b des Gehäuseunterteils 4c plombiert ist. Der Riegel selbst ist in einer Gehäusenut 23 seitlich gehaltert und durch eine Anzahl Gehäusestege 16 in dieser Gehäusenut 23 fixiert.

Die Fig. 2 und die Fig. 3 zeigen, eine Prüföffnung 21, die von einem plombierten Riegel 7, wie er in Fig. 1 gezeigt ist, abgedeckt ist. Eine derartige Prüföffnung 21 erlaubt den Zugriff zu einer in dem Gehäuse 4 installierten Spannungsbrücke 18. Um diese Prüföffnung zu bedienen, ist der Riegel 7 in Fig. 2 in Nutrichtung der Gehäusenut 23 etwas herausgezogen gezeigt.

Eine bekannte Spannungsbrücke 18 ist als Federkontakt in Fig. 3 dargestellt. Sie dient bei Elektrizitätszählern dazu, einen Spannungsmesskreis von einem Strommesskreis während eines Eichprozesses zu trennen. Die Federkontaktausführung ist besonders vorteilhaft wegen der schnellen und einfachen Bedienbarkeit. So muss zu Eichzwecken lediglich eine Prüfspitze 20 durch die Prüföffnung 21 eingeführt werden, wobei der Federkontakt 18 des Spannungsmesskreises von einem Brückenkontakt 19a eines Stromleiters 19 abgehoben wird, und wobei gleichzeitig der auf einer Leiterplatte 22 angeordnete Federkontakt 18 mit einer Prüfspannung beaufschlagt wird.

Im klemmendeckelfreien Zustand waren die Prüföffnungen 21 unverschlossen und eröffneten somit eine unerwünschte Zugriffsmöglichkeit auf den Federkontakt 18. Das erfindungsgemässe Zählergehäuse 4 bewahrt sich nun weiterhin die einfache Bedienbarkeit der Spannungsbrücke 18 zu Prüfzecken, gewährleistet aber gleichzeitig mit dem plombierten Riegel 7 einen einwandfreien und darüber hinaus leicht überprüfbaren Schutz gegen unberechtigten Zugriff.

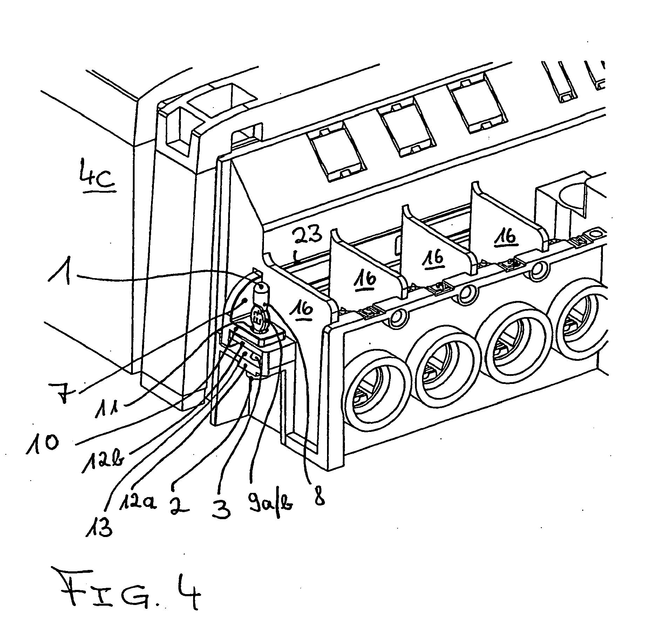

Die Fig. 4 zeigt den plombierten Riegel 7 in vergrösserter Darstellung. Ein Plombierstift 1 verbindet den Riegel 7 mit dem Gehäuseunterteil 4c. Hierfür ist vorgesehen, dass dieser Plombierstift durch eine erste Plombieröse 12a und eine zweite Plombieröse 12b des Gehäuseunterteils 4c und durch die Plombierbohrung 11 der Riegelkonsole 10 geführt wird und anschliessend mittels einer plastischen Verformung 9a gesichert wird.

Einseitig endet der Plombierstift 1 mit einem Stiftkopf 2. Vor einem Plombiervorgang und einer damit verbundenen Fixierung des Plombierstifts 1, weist dieser eine im wesentlichen konstante Dicke auf, mit Ausnahme einer Sollbruchstelle 3, an der der Plombierstift eine entsprechende Verjüngung aufweist. Diese Sollbruchstelle 3 ist derart am Plombierstift angeordnet, dass sie innerhalb der eines Sicht- bzw. Überprüfungsfensters 13 zwischen der ersten und der zweiten Plombieröse 12a, 12b sichtbar ist, wenn der Plombierstift 1 fixiert ist.

Die Riegelkonsole 10 ist ausserhalb des Sichtfensters 13 neben der ersten und/oder zweiten Plombieröse 12a, 12b angeordnet. Selbstverständlich ist ebenfalls denkbar, die Riegelkonsole 10 innerhalb des Sichtfensters 13 zu lokalisieren; allerdings muss das Sichtfenster 13 dann so gestaltet sein, dass dennoch die Sollbruchstelle 3 des Plombierstifts 1 sichtbar bleibt.

Das Sicht- bzw. Überwachungsfenster 13 für die Sollbruchstelle 3 ist klein genug ist, um vor einer unberechtigten Manipulation zu schützen, und ermöglicht darüber hinaus bei dennoch erfolgter Manipulation ein äusserst einfaches Erkennen. Es kann nämlich als unmöglich angesehen werden, den Plombierstift 1 durch Zerstören der Sollbruchstelle 3 zu entfernen, und anschliessend denselben Plombierstift 1 repariert in diesem Überwachungsfenster 13 anzuordnen, ohne dass ein einfacher Kontrollblick diese betrügerische Massnahme unmittelbar offen legen würde.

Eine weitere Verbesserung der Überprüfbarkeit der Plombierung 8 ergibt sich, wenn der Plombierstift 1 aus einem transparenten Kunststoff gefertigt ist, da eine Manipulation stärker ans Licht treten würde.

Die plastische Verformung 9a des Plombierstifts 1 ist mit einem Prägestempelung 9b versehen. Da die plastische Verformung 9a eine Vorderseite und eine Rückseite umfasst, zeigt die Vorderseite das eingeprägte Prüfdatum und die Rückseite eine Kennung der prüfenden Behörde.

### BEZUGSZEICHENLISTE

- 1: Plombierstift
- 2: Stiftkopf
- 3: Sollbruchstelle
- 4: Zählergehäuse
- 4a: Gehäuseabdeckung
- 4b: Klemmendeckel
- 4c: Gehäuseunterteil
- 5: Plombierung der Gehäuseabdeckung 4a
- 6: Plombierung des Klemmendeckels 4b
- 7: Riegel
- 8: Plombierung des Riegels 7
- 9a: plastische Verformung
- 9b: Prägestempelung
- 10: Konsole
- 11: Plombierbohrung
- 12a.: erste Plombieröse
- 12b: zweite Plombieröse
- 13: Sichtfenster .
- 14: Klemmen
- 15: Leiter
- 16: Gehäusestege
- 17: Anschlussöffnungen
- 18: Spannungsbrücke/Federkontakt
- 19: Stromleiter
- 19a: Brückenkontakt
- 20: Prüfspitze
- 21: Prüföffnung
- 22: Leiterplatte
- 23: Gehäusenut

## Patentansprüche

1. Gehäuse für einen Zähler, insbesondere für einen Elektrizitätszähler, Gaszähler, Wärmezähler oder dergleichen, wobei das Gehäuse eine Gehäuseabdeckung (4b) aufweist, mit welcher Gehäuseabdeckung (4b) eine Anzahl Anschlüsse (14) des Zählers gegen unberechtigten Zugriff abcleckbar ist, wobei eine erste Plombierung (6) die Gehäuseabdeckung (4b) sichert, **dadurch gekennzeichnet, dass** durch die Gehäuseabdeckung (4b) eine weitere zu schützende Zählervorrichtung (18) abgedeckt ist, die mittels einer zweiten Plombierung (8) gegen unberechtigten Zugriff schützbar ist, wobei die weitere zu schützende Zählervorrichtung (18) mittels einer Zusatzabdeckung (7) abgedeckt ist, und dass die Zusatzabdeckung (7) als Riegel ausgebildet ist, der seitlich in einer entsprechend angeordneten Gehausenut (23) gehalten ist, oder dass die Zusatzabdeckung (7) als Riegel ausgebildet ist, der von einer Anzahl entsprechend angeordneter Gehäusestege (16) gehalten ist.

2. Gehäuse nach Anspruch 1,
**dadurch gekennzeichnet,**
**dass** die Zusatzabdeckung (7) eine Plombierbohrung (11) aufweist und das Gehäuse eine ersten Plombieröse (12a) aufweist, so dass die Zusatzabdeckung (7) durch ihre Plombierbohrung (11) an der Plombieröse (12a) plombierbar ist.

3. Gehäuse nach Anspruch 2,
**dadurch gekennzeichnet,**
**dass** die Zusatzabdockung (7) mittels eines Plombierstifts (1) sicherbar ist.

4. Gehäuse nach Anspruch 3,
**dadurch gekennzeichnet,**
**dass** die erste Plombieröse (12a) von der Plombierbohrung (11) derart beabstandet ist, dass zwischen der ersten Plombieröse (12a) und der Plombierböhrung (11) ein Zwischenraum (13) ausgebildet ist, so dass in diesem Zwischenraum (13) eine Sollbruchstelle (3) des Plombierstifts (1) sichtbar ist.

5. Gehäuse nach Anspruch 3,
**dadurch gekennzeichnet,**
**dass** das Gehäuse eine weitere, zweite Plombieröse (12b) aufweist, die von der ersten Plombieröse (12a) derart beabstandet ist, dass zwischen der zweiten Plombieröse (12b) und der ersten Plombieröse (12a) ein Zwischenraum (13) ausgebildet ist, in dem eine Sollbruchstelle (3) des Plombierstifts (1) sichtbar ist.

6. Gehäuse nach Anspruch 5,
**dadurch gekennzeichnet,**
**dass** die Plombierbohrung (11) der Zusatzabdeckung (7) ausserhalb des Zwischenraums (13) angeordnet ist.

7. Gehäuse nach einem der Ansprüche 3 bis 5,
**dadurch gekennzeichnet,**
**dass** der Plombierstift (1) aus einem Kunststoff, einem Metall oder einer Metalllegierung besteht.

8. Gehäuse nach einem der Ansprüche 3 bis 5,
**dadurch gekennzeichnet,**
**dass** der Plombierstift (1) aus einem transparenten Kunststoff besteht.

9. Gehäuse nach einem der Ansprüche 3 bis 5,
**dadurch gekennzeichnet,**
**dass** der Plombierstift (1) an einem Ende einen Stiftkopf (2) aufweist, und dass an dem anderen Ende der Plombierstift (1) mittels einer plastischen Verformung (9a) sicherbar ist.

10. Gehäuse nach Anspruch 9,
**dadurch gekennzeichnet,**
**dass** der Plombierstift (1) an der plastischen Verformung (9a) eine Prägestempelung (9b) aufweist.

11. Gehäuse nach Anspruch 10,
**dadurch gekennzeichnet,**
**dass** die Prägestempelung (9b) ein Prüfdatum und/oder eine Kennung einer Flombierungsbehörde aufweist.

## Claims

1. Housing for a meter, in particular for an electricity meter, gas meter, heat meter or the like, wherein the housing has a housing cover (4b), which housing cover (4b) can be used to cover a number of connections (14) of the meter against unauthorized access, wherein a first seal (6) secures the housing cover (4b), **characterized in that** a further meter device (18) to be protected is covered by the housing cover (4b) and can be protected against unauthorized access by means of a second seal (8), wherein the further meter device (18) to be protected is covered by means of an additional cover (7), and **in that** the additional cover (7) is designed as a locking bar which is held laterally in a correspondingly arranged housing groove (23), or **in that** the additional cover (7) is designed as a locking bar which is held by a number of correspondingly arranged housing webs (16).

2. Housing according to Claim 1, **characterized in that** the additional cover (7) has a sealing hole (11) and the housing has a first sealing eye (12a), with the result that the additional cover (7) can be sealed through its sealing hole (11) against the sealing eye (12a).

3. Housing according to Claim 2, **characterized in that** the additional cover (7) can be secured by means of a sealing pin (1).

4. Housing according to Claim 3, **characterized in that** the first sealing eye (12a) is spaced apart from the sealing hole (11) such that a gap (13) is formed between the first sealing eye (12a) and the sealing hole (11), with the result that a predetermined breaking point (3) of the sealing pin (1) is visible in this gap (13).

5. Housing according to Claim 3, **characterized in that** the housing has a further, second sealing eye (12b) which is spaced apart from the first sealing eye (12a) such that a gap (13) is formed between the second sealing eye (12b) and the first sealing eye (12a), in which gap a predetermined breaking point (3) of the sealing pin (1) is visible.

6. Housing according to Claim 5, **characterized in that** the sealing hole (11) in the additional cover (7) is arranged outside the gap (13).

7. Housing according to one of Claims 3 to 5, **characterized in that** the sealing pin (1) is made of a plastic, a metal or a metal alloy.

8. Housing according to one of Claims 3 to 5, **characterized in that** the sealing pin (1) is made of a transparent plastic.

9. Housing according to one of Claims 3 to 5, **characterized in that** the sealing pin (1) has a pin head (2) at one end, and **in that** the sealing pin (1) can be secured at the other end by means of a plastic deformation (9a).

10. Housing according to Claim 9, **characterized in that** the sealing pin (1) has an embossed stamping (9b) on the plastic deformation (9a).

11. Housing according to Claim 10, **characterized in that** the embossed stamping (9b) comprises a test date and/or an identification of a sealing authority.

## Revendications

1. Boîtier pour un compteur, notamment pour un compteur électrique, un compteur à gaz, un compteur thermique ou objets similaires, ledit boîtier présentant un capot (4b), lequel capot (4b) permet de recouvrir un certain nombre de connexions (14) du compteur, afin d'interdire une intervention non autorisée, sachant qu'un premier plombage (6) sécurise ledit capot (4b) du boîtier, **caractérisé par le fait que** le capot (4b) du boîtier recouvre un dispositif supplémentaire de comptage (18) devant être protégé et pouvant être protégé, au moyen d'un second plombage (8), afin d'interdire une intervention non autorisée, ledit dispositif supplémentaire de comptage (18) à protéger étant recouvert au moyen d'un capot additionnel (7) ; et **par le fait que** le capot additionnel (7) est réalisé sous la forme d'un verrou retenu, dans le sens latéral, dans une rainure (23) du boîtier occupant une position correspondante ; ou **par le fait que** ledit capot additionnel (7) est réalisé sous la forme d'un verrou retenu par un certain nombre de membrures (16) du boîtier qui occupent des positions correspondantes.

2. Boîtier selon la revendication 1,
**caractérisé par le fait**
**que** le capot additionnel (7) présente un trou de plombage (11) et ledit boîtier comporte un premier oeillet de plombage (12a), de sorte que ledit capot additionnel (7) peut être plombé au niveau dudit oeillet de plombage (12a), par l'intermédiaire de son trou de plombage (11).

3. Boîtier selon la revendication 2,
**caractérisé par le fait**
**que** le capot additionnel (7) peut être sécurisé au moyen d'une cheville de plombage (1).

4. Boîtier selon la revendication 3,
**caractérisé par le fait**
**que** le premier oeillet de plombage (12a) est espacé du trou de plombage (11), de manière à former un espace interstitiel (13) entre ledit premier oeillet de plombage (12a) et ledit trou de plombage (11), si bien qu'une zone de rupture par destination (3) de la cheville de plombage (1) est visible dans cet espace interstitiel (13).

5. Boîtier selon la revendication 3,
**caractérisé par le fait**
**que** ledit boîtier présente un autre, second oeillet de plombage (12b) qui est espacé du premier oeillet de plombage (12a) de manière à former, entre ledit second oeillet de plombage (12b) et ledit premier oeillet de plombage (12a), un espace interstitiel (13) permettant d'observer une zone de rupture par destination (3) de la cheville de plombage (1).

6. Boîtier selon la revendication 5,
**caractérisé par le fait**
**que** le trou de plombage (11) du capot additionnel (7) est situé à l'extérieur de l'espace interstitiel (13).

7. Boîtier selon l'une des revendications 3 à 5,
**caractérisé par le fait**
**que** la cheville de plombage (1) consiste en une matière plastique, en un métal ou en un alliage métallique.

8. Boîtier selon l'une des revendications 3 à 5,
**caractérisé par le fait**
**que** la cheville de plombage (1) consiste en une matière plastique transparente.

9. Boîtier selon l'une des revendications 3 à 5,
**caractérisé par le fait**
**que** la cheville de plombage (1) est pourvue d'une tête (2) à une extrémité; et par le fait que ladite cheville de plombage (1) peut être sécurisée, à l'autre extrémité, au moyen d'une déformation plastique (9a).

10. Boîtier selon la revendication 9,
**caractérisé par le fait**
**que** la cheville de plombage (1) présente un poinçon embouti (9b) au niveau de la déformation plastique (9a).

11. Boîtier selon la revendication 10,
**caractérisé par le fait**
**que** le poinçon embouti (9b) comporte une date de contrôle et/ou une identification d'une instance officielle de plombage.
